(19) Europäisches Patentamt

European Patent Office

Office européen des brevets

(11) **EP 1 014 099 A2**

(12) **EUROPEAN PATENT APPLICATION**

(43) Date of publication:
**28.06.2000 Bulletin 2000/26**

(51) Int. Cl.[7]: **G01R 31/02**

(21) Application number: **99125509.2**

(22) Date of filing: **21.12.1999**

(84) Designated Contracting States:
**AT BE CH CY DE DK ES FI FR GB GR IE IT LI LU MC NL PT SE**
Designated Extension States:
**AL LT LV MK RO SI**

(30) Priority: **25.12.1998 JP 37160898**
**25.12.1998 JP 37162998**
**25.12.1998 JP 37163898**
**25.12.1998 JP 37164298**

(71) Applicants:
• **N.T.T. Fanet Systems Corporation**
**Shinjuku-ku, Tokyo (JP)**
• **Ntt Telecom Engineering Kansai Co., Ltd.**
**Oosaka-shi, Oosaka-fu (JP)**
• **Brain Child Co., Ltd.**
**Sagamihara-shi, Kanagawa-ken (JP)**

(72) Inventors:
• **Mori, Tadashi,**
**c/o NTT Fanet Systems Corporation**
**Tokyo (JP)**
• **Shindo, Akira,**
**c/o NTT Fanet Systems Corporation**
**Tokyo (JP)**
• **Sakata, Masao,**
**NTT Telecom Eng. Kansai Co. Ltd.**
**Oosaka-shi, Oosaka-fu (JP)**
• **Yoshida, Yuichi,**
**c/o Brain Child Co., Ltd.**
**Sagamihara-shi, Kanagawa-ken (JP)**
• **Sugiyama, Kazuyuki**
**Sagamihara-shi, Kanagawa-ken (JP)**

(74) Representative: **HOFFMANN - EITLE**
**Patent- und Rechtsanwälte**
**Arabellastrasse 4**
**81925 München (DE)**

(54) **Method of and apparatus for identifying cable and method of infusing pilot signal for cable identification**

(57) A target cable has first and second ends that are identified in advance. All conductors of the target cable are electrically short-circuited at the first end of the cable. At the second end of the target cable, pilot signals are infused into a optional number of the conductors of the target cable. The pilot signals produce leakage flux from the target cable anywhere along the target cable. At a given site where the target cable is going to be identified, a magnetic sensor is successively applied to many cables laid around the target cable, to detect the leakage flux. By finding a cable that provides the leakage flux caused by the pilot signals, it is determined that the cable is the target cable.

FIG.1

**Description**

Background of the Invention

1. Field of the Invention

The present invention relates to a method of identifying a target cable among many communication and power cables laid around the target cable at a working site where the target cable is to be marked, cut, or removed. The present invention also relates to an apparatus for achieving the method.

The present invention further relates to an apparatus for infusing a pilot signal into a target cable, to identify the target cable among many cables at a site where the target cable is to be marked, cut, or removed.

2. Description of the Prior Art

Communication cables usually have a length of several kilometers and are frequently laid underground. To remove a communication cable, it must be cut at manholes that are generally positioned at intervals of several tens of meters, and the cut sections of the cable are pulled up to the ground.

The manholes house many communication cables that are more or less the same in appearance, and therefore, it is necessary to identify a target cable to cut at each manhole. For this purpose, facility records must be examined and preliminary surveys must be carried out.

The preliminary surveys are not always enough to eliminate a risk of cutting incorrect cables. To reduce such a risk, a special cutter is used to cut a cable. This cutter is a potential detecting cutter capable of determining by itself whether or not an immediate cable must be cut.

A communication cable generally consists of pairs of conductors. In each conductor pair, one is grounded and the other passes a communication signal at a fixed voltage. The conductors are collected, shielded, and sheathed to form a communication cable.

The potential detecting cutter has a metal blade provided with a potential sensing function to monitor the potential of the conductor of a conductor that is in contact with the blade. If this conductor is of an incorrect cable, the conductor must be grounded or at a fixed communication voltage. Accordingly, once detecting the ground potential or the fixed communication voltage, the blade immediately stops not to cut the incorrect cable, although the jacket of the cable will have a cut by the blade. This technique improves the reliability of cable removing or replacing work.

A shield under the sheath of a communication cable not only protects conductors but also prevents static induction between adjacent cables. Accordingly, the shield is grounded, and the potential detecting cutter stops as soon as it detects the ground potential of the shield. Due to this mechanism, the cable sheath and metal shield of a target communication cable to be cut must be bared at each end thereof to make the shield ungrounded. Thereafter, the potential detecting cutter is used at a working site to cut the target cable. These processes are complicated and troublesome.

Although the prior art is capable of preventing cuts of incorrect cables, it requires the cable sheath and shield of a target cable to be cut at a start point, a working point, and an end point. If an incorrect cable is going to be cut and stopped, it may have a slight scar that must be repaired. Consequently, the prior art takes a long time to remove a cable, in particular, a long cable.

Summary of the Invention

An object of the present invention is to provide a method of correctly identifying a target cable in a short time without using the potential detecting cutter, and an apparatus for achieving the method.

Another object of the present invention is to provide an apparatus for infusing a pilot signal into an end of a target cable with a short preparatory time.

In order to accomplish the objects, a first aspect of the present invention provides a method of identifying a target cable containing many conductors covered with a cable sheath. The method includes the steps of short-circuiting all conductors of the target cable at a first end of the target cable, infusing a pilot signal into a plurality of the conductors at a second end of the target cable, arranging a magnetic sensor for detecting leakage flux, around an optional cable at a site where the target cable is going to be identified, and determining, according to the output of the magnetic sensor, whether or not the optional cable is the target cable.

The pilot signal infused into the second end of the target cable produces leakage flux around the target cable at any location along the target cable. The magnetic sensor quickly detects the leakage flux at a given site and correctly identifies the target cable among many cables laid around the target cable.

A second aspect of the present invention provides a method of identifying a target cable containing many conductors covered with a cable sheath. The method includes the steps of short-circuiting all conductors of the target cable at a first end of the target cable, infusing alternating pilot signals of the same frequency and different phases shifted by a predetermined angle into at least three of the conductors at a second end of the target cable, arranging a magnetoelectric converter around an optional cable at a site where the target cable is going to be identified, so that diametrical magnetic flux emanating from the optional cable may cross the magnetoelectric converter, comparing a composite waveform of voltage signals provided by the magnetoelectric converter with a reference waveform representing the pilot signals, and determining, according to a result of the comparison, whether or not the optional cable is the target cable.

The second aspect infuses alternating pilot signals of a single frequency and shifted phases into at least three conductors of a target cable. The pilot signals produce a rotating magnetic field around the at least three conductors anywhere along the target cable. As a result, a magnetic field of substantially the same strength is detectable anywhere around and along the target cable, so that the target cable may quickly be identified.

A third aspect of the present invention provides a method of identifying a target cable containing many conductors covered with a cable sheath. The method includes the steps of short-circuiting all conductors of the target cable at a first end of the target cable, infusing alternating pilot signals of different frequencies into at least a pair of the conductors at a second end of the target cable, arranging a magnetoelectric converter around an optional cable at a site where the target cable is going to be identified, so that diametrical magnetic flux emanating from the optional cable may cross the magnetoelectric converter, analyzing a voltage signal induced by the magnetic flux in the magnetic converter into a frequency distribution, comparing the frequency distribution with a frequency distribution of the pilot signals, and determining, according to a result of the comparison, whether or not the optional cable is the target cable.

The third aspect infuses alternating pilot signals of different frequencies into at least a pair of conductors of a target cable. The pilot signals cause the target cable to emanate leakage flux, and the magnetoelectric converters that detect the leakage flux provide voltage signals whose frequency distribution has peaks at specific frequencies. The waveform or frequency distribution of the output signals is compared with that of the pilot signals, to correctly identify the target cable.

The present invention may short-circuit all conductors of a target cable at an end face thereof by entirely coating the end face with conductive material. This short-circuiting work is easy and quick, thereby improving the efficiency of cable identification work.

The present invention may infuse alternating pilot signals into four conductors of one of star quads in a target cable. In this case, opposing two of the four conductors receive a first pilot signal, and the remaining two receive a second pilot signal whose phase is shifted by 90 degrees from that of the first pilot signal. The pilot signals produce a rotating magnetic field around the target cable at any location along the target cable with a period of the rotating magnetic field corresponding to the frequencies of the pilot signals. As a result, a magnetic field of substantially the same strength is detectable anywhere around and along the target cable, to make the target cable identifiable quickly.

The present invention may arrange four magnetoelectric converters at intervals of 90 degrees around an optional cable. Opposing two of the four magnetoelectric converters provide voltage signals to form a first composite waveform, and the remaining two provide voltage signals to form a second composite waveform. The first and second composite waveforms are added to each other on a frequency axis to form a sum waveform. The sum waveform is compared with a reference waveform representing the pilot signals, to determine whether or not the optional cable is a target cable. Compared with oppositely arranging two magnetoelectric converters, arranging four magnetoelectric converters improves sensitivity to pilot signals and correctness of cable identification.

A fourth aspect of the present invention provides a cable identifying apparatus of a target cable. The apparatus includes conductive material placed at a first end of the target cable to short-circuit all conductors of the target cable, an infuser infusing a pilot signal into a plurality of the conductors at a second end of the target cable, a magnetic sensor applied to an optional cable at a site where the target cable is going to be identified, to determine whether or not the optional cable leaks magnetic flux caused by the pilot signal, and an evaluation circuit determining, according to the output of the magnetic sensor, whether or not the optional cable is the target cable.

The conductive material is used to short-circuit all conductors of a target cable at a first end of the target cable. The infuser infuses a pilot signal into a plurality of the conductors at a second end of the target cable. The pilot signal produces leakage flux around the target cable at any location along the target cable. The magnetic sensor is used at a working site to detect the leakage flux caused by the pilot signal and quickly and correctly identify the target cable at the site among many cables laid around the target cable.

A fifth aspect of the present invention provides a cable identifying apparatus of a target cable. The apparatus short-circuits all conductors of the target cable at a first end thereof, infuses alternating pilot signals having a single frequency and phases shifted by a predetermined angle into an optional number of the conductors at a second end of the target cable, checks, at a working site, to see if an optional cable leaks magnetic flux caused by the pilot signals, and determines whether or not the optional cable is the target cable. The apparatus consists of a magnetic sensor and a signal processor. The magnetic sensor has at least a pair of magnetoelectric converters that are oppositely arranged around the optional cable at the site, to cross diametrical magnetic flux emanating from the optional cable. The signal processor combines voltage signals provided by each pair of the magnetoelectric converters into a composite waveform, compares the composite waveform with a reference waveform, and determines whether or not the optional cable is the target cable.

The fifth aspect short-circuits all conductors of a target cable at a first end of the target cable and infuses alternating pilot signals into an optional number of the conductors at a second end of the target cable. At a working site, the magnetoelectric converters are applied to an optional cable to detect diametrical magnetic flux emanating from the optional cable. The signal processor combines voltage signals provided by the magnetoelectric converters into a composite waveform, compares the composite waveform with a reference waveform, and determines whether or not the optional cable is the target cable.

Leakage flux due to the pilot signals forms a rotating magnetic field of substantially the same strength anywhere around and along the target cable. The fifth aspect detects the leakage flux and identifies the target cable.

The fifth aspect may arrange four magnetoelectric converters at intervals of 90 degrees around an optional cable. Opposite two of the magnetoelectric converters forms a pair, and voltage signals from the two pairs are combined into a composite waveform. Even if leakage flux from the optional cable fluctuates in direction and strength, the magnetoelectric converters complement each other to properly detect the magnetic flux, thereby correctly determining whether or not the optional cable is a target cable.

A sixth aspect of the present invention provides a cable identifying apparatus of a target cable. The apparatus short-circuits all conductors of the target cable at a first end thereof, infuses alternating pilot signals of a single frequency into an optional number of the conductors at a second end of the target cable. At a working site, an optional cable is checked to see if it leaks magnetic flux caused by the pilot signals, and it is determined if the optional cable is the target cable. The apparatus includes a magnetic sensor that consists of a plurality of magnetoelectric converters arranged around the optional cable at the site, to cross diametrical magnetic flux emanating from the optional cable. The apparatus further has a spectrum analyzer carrying out a frequency spectrum analysis on voltage signals provided by the magnetoelectric converters, a processor adding up frequency spectrum intensities provided by the spectrum analyzer and providing a frequency spectrum distribution, and a comparator comparing the frequency spectrum distribution with a reference frequency spectrum distribution representing the pilot signals, and according to a result of the comparison, determining whether or not the optional cable is the target cable.

The sixth aspect short-circuits all conductors of a target cable at a first end thereof, infuses alternating pilot signals of a single frequency into an optional number of the conductors at a second end of the target cable. At a working site, the magnetoelectric converters provide voltage signals whose frequency spectra are analyzed by the frequency spectrum analyzer. The processor adds up spectrum intensities of respective frequencies provided by the spectrum analyzer and computes a frequency spectrum distribution. The comparator compares the frequency spectrum distribution with a reference frequency spectrum distribution corresponding to the pilot signals. According to a result of the comparison, the comparator determines whether or not the optional cable is the target cable.

The sixth aspect never cancels voltage signals provided by the magnetoelectric converters. Instead, the sixth aspect adds up the voltage signals to provide a frequency spectrum distribution. The frequency spectrum distribution is compared with a frequency spectrum distribution representing the pilot signals, to correctly identify the target cable.

The sixth aspect may employ alternating pilot signals of different frequencies. Provided spectrum distribution of different frequencies are compared with that of the pilot signals, to more correctly identify a target cable.

The thickness of each of the magnetoelectric converters in the longitudinal direction of a target cable may be 1/4 or below a strand pitch of conductors that pass pilot signals in the target cable. This improves the directivity of the magnetoelectric converter with respect to diametrical leakage flux emanating from the target cable and the correctness of target cable identification.

Each of the magnetoelectric converters may have a magnetic shield on the outer and side faces thereof with only the inner face thereof being open. This structure improves the directivity of the magnetoelectric converter with respect to diametrical leakage flux emanating from a target cable and the correctness of target cable identification.

Each of the magnetoelectric converters may consist of converter elements that are circumferentially arranged side by side and are connected in series. Four such magnetoelectric converters may be arranged at intervals of 90 degrees around an optional cable. Voltage signals provided by opposing two of the magnetoelectric converters are added to each other, and voltage signals provided by the remaining magnetoelectric converters are added to each other. Even if magnetic flux from the optional cable fluctuates in direction and strength, one of the magnetoelectric converters may properly detect the magnetic flux. This arrangement is capable of properly detecting even weak magnetic flux, to further improve the correctness of target cable identification.

A seventh aspect of the present invention provides an infuser infusing alternating pilot signals to identify a target cable containing many conductors covered with a cable sheath. The infuser infuses the pilot signals into an optional number of the conductors in the target cable. The infuser has a base attached to the cable sheath of the target cable, an arm supported by the base and extending toward an end face of the target cable with the base being attached to the sheath, contacts attached to the arm and brought in contact with end faces of the optional number of conductors, respectively, at the end face of the target cable, and leads connected to the contacts, respectively, to guide the pilot signals.

According to the seventh aspect, the infuser infuses pilot signals into an optional number of the conductors at an end face of the target cable. The base of the infuser is attached to the cable sheath of the target cable, and the arm supported by the base faces the end face of the target cable. The contacts attached to the arm of the infuser are brought in contact with end faces of the optional number of conductors. The infuser sends the pilot signals to the contacts, which guide the pilot signals to the end faces of the optional number of conductors.

Each of the contacts has probes incorporating a spring therein and independently movable. One of the probes of each contact surely catches a conductor to supply a pilot signal to the conductor.

The arm of the infuser may have a first adjusting mechanism for adjusting the positions of the contacts in an axial direction along a target cable and a second adjusting mechanism for adjusting the positions of the contacts in a direction orthogonal to the axial direction. This arrangement easily brings the contacts in contact with conductors on an end face of a target cable to supply pilot signals to the conductors.

An eighth aspect of the present invention provides a pilot signal generator having a frequency signal generator for generating alternating signals of a given frequency, a first output circuit for providing a first pilot signal of a predetermined current intensity based on the generated alternating signals, a second output circuit for providing a second pilot signal of a predetermined current intensity based on the generated alternating signals, an isolation transformer arranged between the frequency signal generator and the first output circuit, and an isolation transformer arranged between the frequency signal generator and the second output circuit, both the isolation transformers isolating the first and second output circuits from each other.

The frequency signal generator generates alternating signals of a given frequency, and the first and second output circuits provide first and second pilot signals of predetermined intensities based on the generated alternating signals. The pilot signals are supplied to an infuser and from which to two pairs of conductors at an end of a target cable. The isolation transformers isolate the first and second output circuits from each other, to prevent interference between the pilot signals and improve the correctness of target cable identification.

The frequency signal generator may be configured to generate alternating signals of different frequencies, to provide pilot signals of different frequencies.

The frequency signal generator may be configured to provide the first and second output circuits with alternating signals of the same frequency and different phases shifted by 90 degrees from each other. These pilot signals produce leakage flux that causes a rotating magnetic field around a target cable.

Brief Description of the Drawings

Figure 1 shows the principle of a method of identifying a target cable according to the present invention;
Fig. 2 is a sectional view showing a communication cable;
Fig. 3 is a sectional view showing a quad of the cable of Fig. 2;
Fig. 4 shows changes in the position of a quad and strands thereof in the cable of Fig. 2;
Fig. 5 is a sectional view showing a quad into which pilot signals are infused according to the present invention;
Fig. 6 is a circuit diagram showing the principle of a method of identifying a target cable according to the present invention;
Fig. 7 is a circuit diagram showing a generator for generating 2-phase multi-frequency pilot signals according to the present invention;
Fig. 8 shows rotating magnetic flux caused by pilot signals infused into a quad of a cable according to the present invention;
Fig. 9 shows a magnetic sensor of a cable identifying apparatus of a target cable according to the present invention;
Fig. 10 shows an operation of the magnetic sensor of Fig. 9;
Fig. 11 is a circuit diagram showing a pilot signal receiver of the cable identifying apparatus of a target cable according to the present invention;
Fig. 12 is a block diagram showing a signal processor of the pilot signal receiver of Fig. 11;
Fig. 13 is a flowchart showing a cable evaluation process carried out by the signal processor of Fig. 12;
Fig. 14 shows examples of frequency spectrum distributions used for the cable evaluation process of Fig. 13;
Fig. 15A shows a plan front view of a magnetic sensor having divided magnetoelectric converters according to the present invention;
Fig. 15B shows a front view of the magnetic sensor of Fig. 15A;

Fig. 16A shows a plan view of the magnetic sensor of Fig. 15A;

Fig. 16B shows a partly broken front view of the magnetic sensor of Fig. 15A;

Fig. 17 shows a usage of the magnetic sensor of Fig. 15A;

Fig. 18 is a circuit diagram showing the magnetic sensor of Fig. 15A;

Fig. 19 shows a magnetic circuit of the magnetic sensor of Fig. 15A;

Fig. 20A shows a flux detecting operation of the magnetic sensor of Fig. 15A;

Fig. 20B shows a flux detecting operation of the magnetic sensor of Fig. 9;

Fig. 21 is a perspective view showing a pilot signal infuser according to the present invention;

Fig. 22 shows front and side views of the pilot signal infuser of Fig. 21;

Fig. 23 shows sectional and side views of a head and contacts of the pilot signal infuser of Fig. 21;

Fig. 24 shows a usage of the pilot signal infuser of Fig. 21;

Fig. 25 is a graph showing the characteristics of a magnetic sensor having four magnetoelectric converters each having three converter elements of detecting single-phase pilot signals according to the present invention;

Fig. 26 is a graph showing the characteristics of a magnetic sensor having four magnetoelectric converters each having three converter elements of detecting 2-phase pilot signals according to the present invention;

Fig. 27 is a graph showing the characteristics of a magnetic sensor having four magnetoelectric converters each having a single converter element of detecting 2-phase pilot signals according to the present invention; and

Fig. 28 is a graph showing the characteristics of a magnetic sensor having four magnetoelectric converters each having a single converter element of detecting single-phase pilot signals.

Detailed Description of the Embodiments

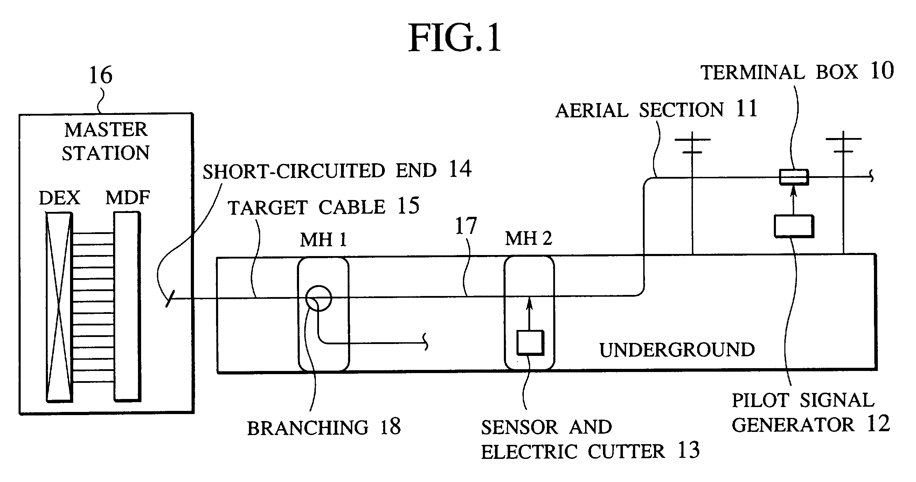

The principle of a method of identifying a target cable according to the present invention will be explained with reference to Fig. 1. A multicore communication cable 15 such as a telephone cable contains many insulated conductors and is extended from a station 16 into an underground pipe and is branched at a location 18. In a residential area, the cable 15 is stretched over poles to a terminal box 10, which further branches the cable 15 up to subscriber homes. When the cable 15 must be removed, it is cut into sections in manholes MH1 and MH2 by workers.

The underground pipe houses not only the cable 15 but also other communication cables and power cables side by side, and it is nearly impossible to distinguish the cable 15 from the others from appearance. The cable 15, however, must correctly be identified among the like cables. If an incorrect communication cable is erroneously cut, telephones in a vast area will be stopped.

To correctly identify the cable 15, the cable identification method is achieved in each of the manholes MH1 and MH2 where the cable 15 is cut and removed. After the cable 15 is identified, it is marked or cut.

Each end of the cable 15 is identifiable in advance. At the first end 14 of the cable 15, all conductors of the cable 15 are short-circuited. At the second end of the cable 15, alternating pilot signals produced by a pilot signal generator 12 are infused into an optional number of the conductors of the cable 15. In the manhole MH2 that is closest to the pilot signal infusing location, a magnetic sensor 13 is attached to many cables one after another. The target cable 15 is passing the pilot signals, and therefore, the target cable 15 leaks magnetic flux produced by the pilot signals. The magnetic sensor 13 detects the leakage flux to identify the target cable 15. Once the target cable 15 is identified, it is marked or cut.

For example, the target cable 15 is marked in the manhole MH2, and the same identification method is carried out in the next manhole MH1 and in other manholes or sites up to the first end 14 of the cable 15 where the conductors thereof have been short-circuited.

Alternatively, the cable 15 is cut in the manhole MH2, the sheath of the cable 15 is removed at the cut end, and pilot signals are infused into an optional number of conductors at the cut end of the cable 15. Then, the cable identification method is carried out in the manhole MH1 to cut the cable 15 again. These processes are repeated up to the first end 14 of the cable 15 where the conductors thereof have been short-circuited.

The short-circuiting process at the first end 14 may be carried out by simply attaching a metal sheet to the whole cut surface of the first end 14. To surely short-circuit all conductors of the target cable 15, liquid conductive material may be coated or sprayed over the first end 14 and dried. The liquid conductive material surely short-circuits all conductors that are exposed at the first end 14. The liquid conductive material may be a mixture of metal powder and binder such as copper-acrylic or nickel-acrylic material. Any material having a dry electric resistance of 1 $\Omega$/sq (35 $\mu$m) or below and a dry time of 30 minutes or shorter is preferable.

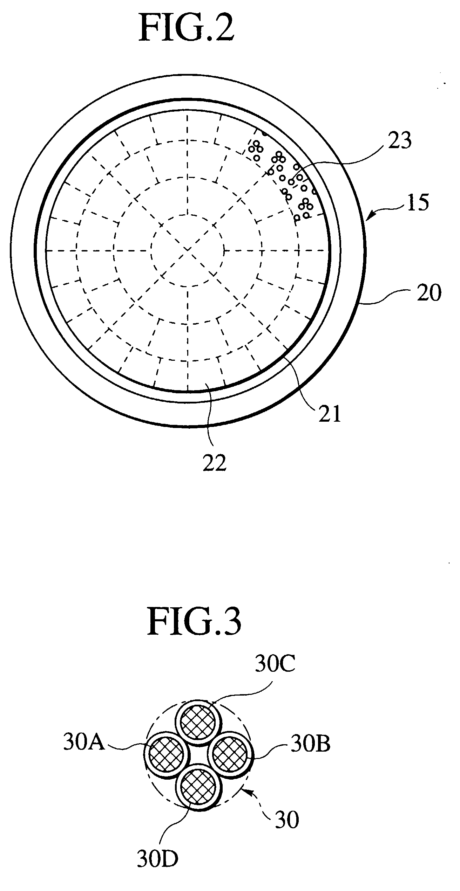

A general structure of a standard communication cable 15 will be explained with reference to Figs. 2 to 4. In Fig. 2, the cable 15 has a cable sheath 20 backed by a shield 21. The shield 21 contains many insulated conductors 23 that are collected into bundles 22 each containing, for example, 50 conductors 23. In Fig. 3, a star arrangement of two pairs of four conductors 30A to 30D forms a quad 30. Each quad is used as a unit to transmit a communication signal from one end of the cable 15 to the other.

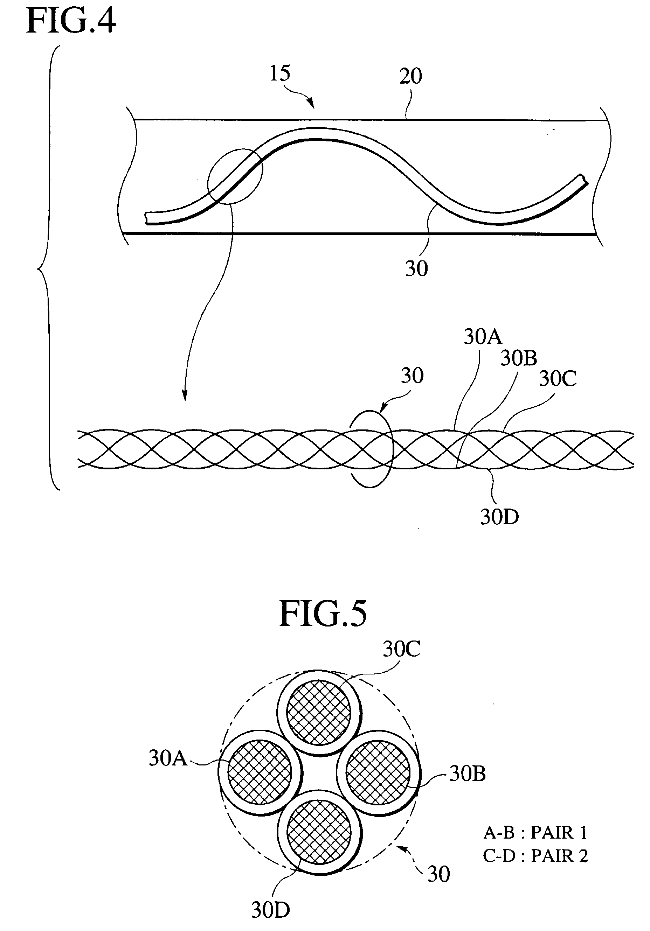

Figure 4 shows an axial structure of the communication cable 15. The four conductors 30A to 30D of each quad 30 are stranded, and the quads 30 in the cable sheath 20 are also stranded to form a spiral.

Based on the principle of the present invention and the cable structure mentioned above, methods and apparatuses for identifying a target cable and pilot signal infusers according to the present invention will be explained in detail.

Figures 5 to 8 show a method of infusing alternating pilot signals into the conductors 30A to 30D of a quad 30 and an infuser used to infuse the pilot signals.

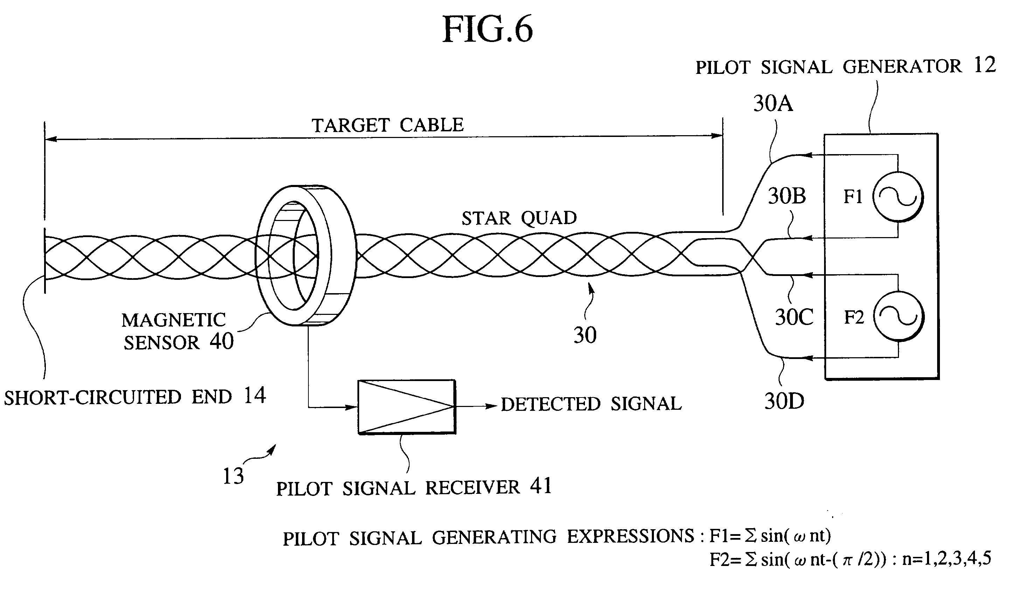

Among the conductors 30A to 30D, the opposing conductors 30A and 30B form a pair, and the other opposing conductors 30C and 30D form another pair. These pairs receive alternating two-phase multi-frequency pilot signals F1 and F2, respectively, as shown in Fig. 6.

In this embodiment, the pilot signals F1 and F2 are selected such that their frequencies differ from those of communication control signals and such that harmonics of their frequencies do not interfere with each other. The phase of the pilot signal F1 is delayed from that of the pilot signal F2 by 90 degrees. The pilot signals F1 and F2 employ, for example, five frequencies of $\omega 1$ = 1000 Hz, $\omega 2$ = 1850 Hz, $\omega 3$ = 2650 Hz, $\omega 4$ = 3450 Hz, and $\omega 5$ = 4300 Hz. These frequencies are in the range of 1 kHz to 10 kHz to eliminate the influence of harmonics of commercial frequencies and avoid the influence of leakage flux from power lines.

The frequencies, however, do not limit the present invention. The present invention may employ any frequencies. Conditions to select frequencies for pilot signals will be explained. Acceptable frequencies are in a voice band used for telephone lines. To avoid the influence of leakage flux from power lines, preferable frequencies are in the range of 1 kHz to 10 kHz. In consideration of attenuation characteristics, preferable frequencies are in the range of 1 kHz to 4.5 kHz excluding frequencies used for modem carrier signals, fax signals, and tone dial signals. The frequencies to be selected must be free from the influence of harmonics thereof.

In principle, the pilot signals F1 and F2 may have the same single frequency and different phases shifted by 90 degrees from each other. One of the pilot signals F1 and F2 is infused into a pair of conductors of a target cable, and the other into another pair of conductors of the target cable, to identify the target cable with the pilot signals. Also the multi-frequency pilot signals may be infused into a single pair of conductors of a target cable.

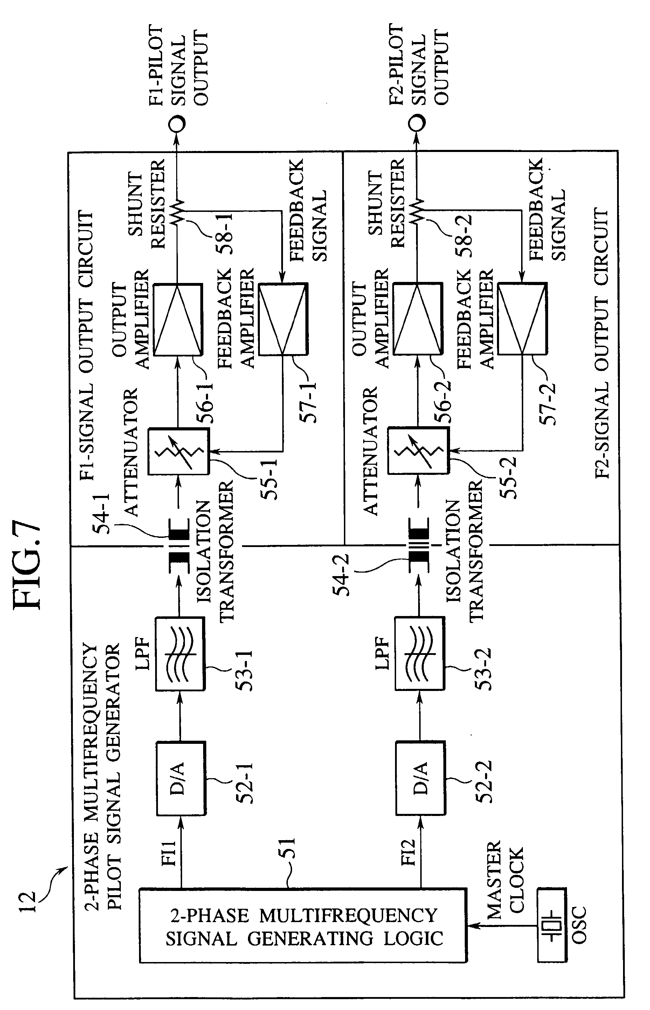

Figure 7 shows a pilot signal generator for generating the pilot signals F1 and F2. The pilot signal generator 12 consists of a 2-phase multi-frequency signal generator, an F1-output circuit for providing the first pilot signal F1, and an F2-output circuit for providing the second pilot signal F2.

In the 2-phase multi-frequency signal generator, an oscillator OSC generates a master clock signal. Based on the master clock, signal generating logic circuit 51 generates a digital signal FI1 corresponding to the 5-frequency pilot signal F1 and a digital signal FI2 corresponding to the 5-frequency pilot signal F2 whose phase is shifted from that of the pilot signal F1 by 90 degrees, as follows:

$$FI1 = \Sigma \sin(\omega n \cdot t) \qquad n = 1,2,3,4,5$$

$$FI2 = \Sigma \sin(\omega n \cdot t - \frac{\pi}{2}) \qquad n = 1,2,3,4,5$$

The digital signals FI1 and FI2 are converted into analog signals by D/A converters 52-1 and 52-2, respectively. The analog signals are passed through low-pass filters (LPF) 53-1 and 53-2, respectively, to remove harmonics. The harmonics-removed signals are supplied to the F1- and F2-output circuits, respectively.

Isolation transformers 54-1 and 54-2 are arranged between the 2-phase multi-frequency signal generator and the F1- and F2-output circuits, to isolate the F1- and F2-output circuits from each other and transfer the analog signals from the LPF 53-1 and 53-2 to the F1- and F2-output circuits.

In the F1- and F2-output circuits, attenuators 55-1 and 55-2 modify the alternating signals from the 2-phase multi-frequency signal generator into waveforms having proper amplitudes according to signals fed back through feedback amplifiers 57-1 and 57-2. The modified signals are amplified by output circuits 56-1 and 56-2. The amplified signals are passed through shunt resistors 58-1 and 58-2, which provide the pilot signals F1 and F2. The pilot signals F1 and F2 are infused into the four conductors of a given quad 30. The shunt resistors 58-1 and 58-2 receive the amplified signals from the output circuits 56-1 and 56-2, produce feedback signals whose voltages are proportional to the received signals, and send the feedback signals to the feedback amplifiers 57-1 and 57-2. The feedback amplifiers 57-1 and 57-2 and attenuators 55-1 and 55-2 carry out a feedback control operation to stabilize the outputs of the output circuits 56-1 and 56-2, or the feedback voltage signals from the shunt resistors 58-1 and 58-2.

The isolation transformers 54-1 and 54-2 isolate the F1- and F2-output circuits from each other so that each amplifier may not be interfered by the frequency signal of the other.

In the pilot signal generator 12 of Fig. 7, each intensity of the pilot signals F1 and F2 infused into the cable 15 can be fixed without regard to the line resistance of the cable 15 that is dependent on the diameter and length of the cable 15.

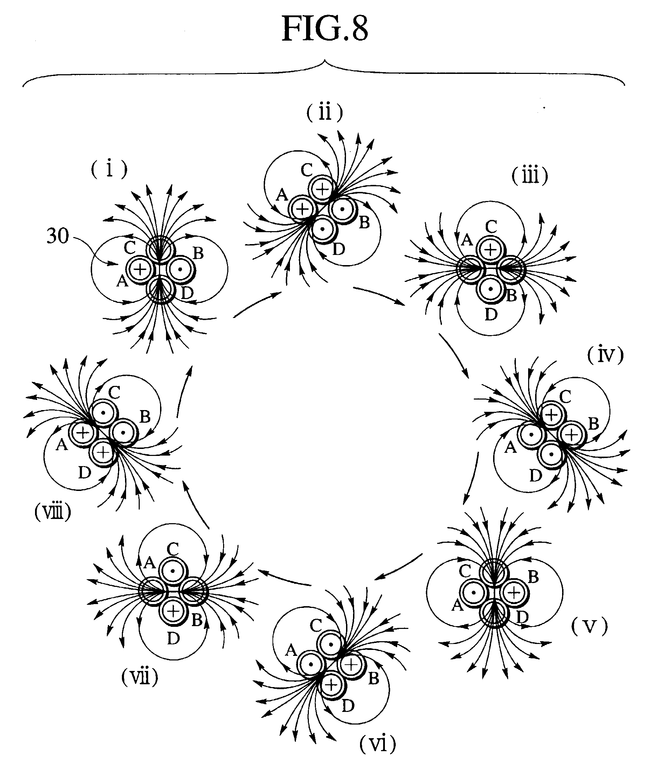

Figure 8 shows a magnetic field produced by the pilot signals F1 and F2 infused into a quad 30 in the cable 15. The magnetic field produced by the pilot signals F1 and F2 around the conductors 30A to 30D of the quad 30 is a rotating magnetic field that is uniform at any axial location along the cable 15.

If the signal flowing through the conductor 30A is at a maximum value (phase = 90 degrees) in a state (i) of Fig. 8, the signal flowing through the conductor 30B that forms a pair with the conductor 30A is at a minimum value (phase = -90 degrees). The phase of the signal in the conductor 30C is 90 degrees behind the phase of the signal in the conductor 30A, and therefore, the value thereof is 0 (phase = 0 degrees), and the signal in the conductor 30D that is paired with the conductor 30C is also at a value of 0 (phase = -180 degrees).

When the phase advances 45 degrees to a state (ii) of Fig. 8, the phase of the signal in the conductor 30A is 135 degrees and that of the signal in the conductor 30C is 45 degrees to take a value of $1/\sqrt{2}$, and the phase of the signal in the conductor 30B is -45 degrees and that of the signal in the conductor 30D is -135 degrees also to take a value of $1/\sqrt{2}$.

The signals sequentially take states (iii) to (viii) of Fig. 8 and return to the state (i).

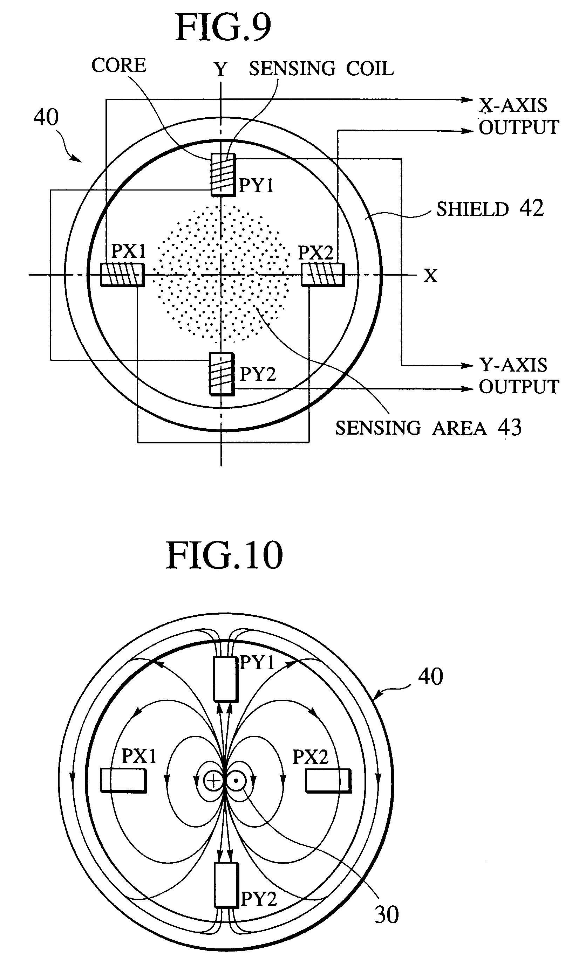

The magnetic field produced around the quad 30 is a rotating magnetic field anywhere along the cable 15, and therefore, leakage flux from the cable 15 also rotates. To detect the leakage flux, a magnetic sensor 40 of Fig. 9 is arranged around the cable 15 as shown in Fig. 6. The magnetic sensor 40 measures the leakage flux. More precisely, the magnetic sensor 40 is composed of X-axis sensing coils PX1 and PX2 serving as magnetoelectric converters and Y-axis sensing coils PY1 and PY2 also serving as magnetoelectric converters to detect leakage flux passing through the sensing coils.

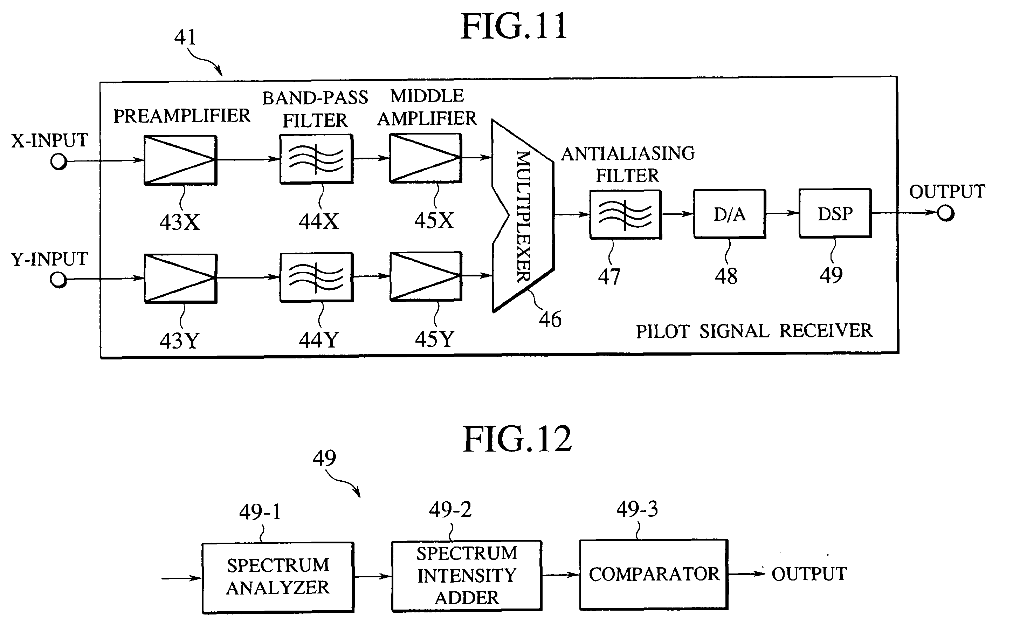

The magnetic sensor 40 and a pilot signal receiver 41 (Figs. 6 and 11) form the cable identifying apparatus of a target cable according to the present invention. A structure of the magnetic sensor 40 will be explained. A ring shield 42 blocks the influence of external magnetism. The sensing coils PX1, PY1, PX2, and PY2 are arranged at intervals of 90 degrees along the inner circumference of the shield 42. The sensing coils have each a core and are arranged to cross diametrical magnetic flux emanating from a cable to inspect. For the sake of simplicity of explanation, a horizontal direction is an X-axis direction and a vertical direction is a Y-axis direction. The sensing coils PX1 and PX2 are on the X-axis, and the sensing coils PY1 and PY2 are on the Y-axis.

The sensing coils PX1 and PX2 are wound to add up voltages induced by magnetic flux of the same direction and are connected in series. Similarly, the sensing coils PY1 and PY2 are wound to add up voltages induced by magnetic flux of the same direction and are connected in series.

Figure 10 shows a distribution of magnetic flux produced at a given moment around the quad 30 by the pilot signals F1 and F2. Although Fig. 10 shows two conductors for easy understanding, the quad 30 actually has four conductors to pass the 2-phase multi-frequency pilot signals.

Diametrical magnetic flux of large density emanating from the quad 30 passes through the sensing coils PY1 and PY2 to induce voltages (positive in this example). The induced voltages are added to each other to provide a large voltage signal as a Y-axis output. At this time, an X-axis output is nearly zero.

When the phases of the pilot signals advance 90 degrees, the magnetic flux rotates 90 degrees as shown in Fig. 8. Then, the diametrical magnetic flux of large density emanating from the quad 30 passes through the sensing coils PX1 and PX2 to induce voltages. The induced voltages are added to each other to provide a large voltage signal as the X-axis output. At this time, the Y-axis output is nearly zero.

When the phases of the pilot signals further advance 90 degrees, the sensing coils PY1 and PY2 provide a large voltage signal in the opposite direction (negative) as the Y-axis output. At this time, the X-axis output is nearly zero.

When the phases of the pilot signals further advance 90 degrees, the sensing coils PX1 and PX2 provide a large voltage signal in the opposite direction (negative) as the X-axis output. At this time, the Y-axis output is nearly zero.

In this way, the magnetic sensor 40 applied to the cable 15 that contains the quad 30 that is passing the alternating 2-phase pilot signals provides X- and Y-axis output signals whose frequencies substantially agree with those of the pilot signals. Since the pilot signals are multi-frequency signals, the output signals provided by the magnetic sensor 40 involve the corresponding frequencies.

Figure 11 shows the pilot signal receiver 41 for receiving the X- and Y-axis output signals from the magnetic sensor 40 and determining whether or not the cable to which the magnetic sensor 40 is applied is the target cable 15.

The pilot signal receiver 41 receives the X-axis output from the magnetic sensor 40 as an X-input and the Y-axis output thereof as a Y-input. Preamplifiers 43X and 43Y amplify the weak X- and Y-inputs. Band-pass filters 44X and 44Y remove frequency signals that are outside the frequency band (1000 Hz to 4500 Hz in this example) of the pilot signals. Middle amplifiers 45X and 45Y amplify the outputs of the band-pass filters 44X and 44Y and provide a multiplexer 46 with the amplified signals.

The multiplexer 46 alternately passes the signals from the middle amplifiers 45X and 45Y at predetermined intervals. As a result, the X- and Y-input signals are alternately supplied to an A/D converter 48 through an antialiasing filter 47 for a predetermined period. The antialiasing filter 47 is a low-pass filter for passing signals whose frequencies are below 4500 Hz. The A/D converter 48 converts the X- and Y-signals from the multiplexer 46 into digital signals, which are transferred to a digital signal processor 49.

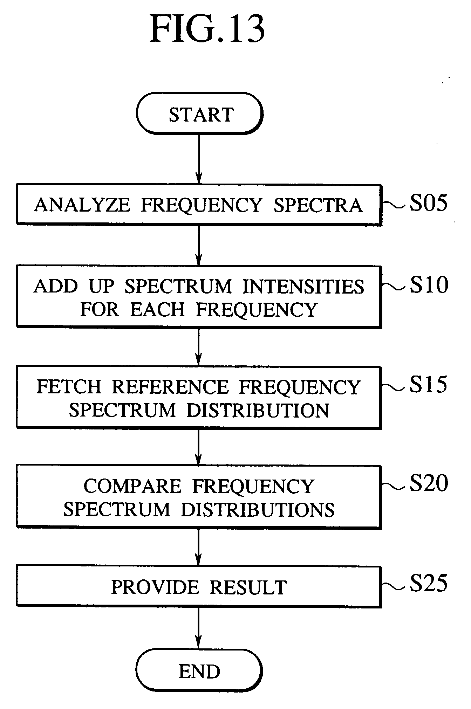

Figures 12 and 13 show functions of the digital signal processor 49. In step S05, a frequency spectrum analyzer 49-1 of the signal processor 49 analyzes the spectrum intensity of each frequency of an input multi-frequency digital signal. In step S10, a spectrum intensity adder 49-2 adds up the spectrum intensity of each frequency and computes a frequency spectrum distribution. The frequency spectrum distribution is transferred to a comparator 49-3.

In steps S15 and S20, the comparator 49-3 compares the characteristics of the spectrum distribution provided by the spectrum intensity adder 49-2 with the characteristics of a reference spectrum distribution corresponding to the 2-phase multi-frequency pilot signals that are stored in advance. If the compared characteristics substantially agree with each other, it is determined that the magnetic sensor 40 has detected the pilot signals. Then, a target cable detected signal is provided in step S25.

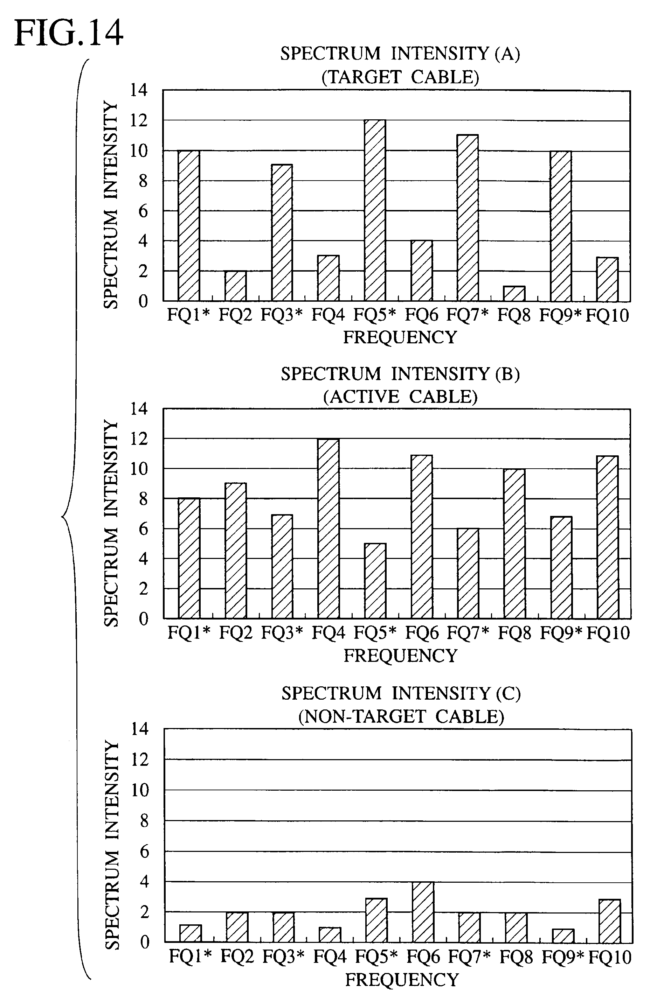

Figure 14 shows examples of cable evaluations carried out by the comparator 49-3. Each graph in Fig. 14 shows frequency spectra FQ1 to FQ10 analyzed from voltage signals detected by the magnetic sensor 40. Among the frequencies FQ1 to FQ10, the frequencies FQ1, FQ3, FQ5, FQ7, and FQ9 marked with an asterisk "*" correspond to the frequencies of the pilot signals.

(A) Figure 14(A) shows that noise levels are low (for example, the difference between a noise level and an average spectrum intensity is 24 dB or greater) and that the intensities of frequency spectra corresponding to the pilot signal frequencies are substantially uniform (for example, a spectrum intensity difference among the five frequencies is within 6 dB). Then, it is determined that the cable to which the magnetic sensor 40 is applied is the target cable.
(B) Figure 14(B) shows that the spectrum intensities of the frequencies FQ2, FQ4, FQ6, FQ8, and FQ10 are large to indicate large noise levels. Then, it is determined that the cable to which the magnetic sensor 40 is applied is an active cable that is passing large current, and therefore, that the cable is not the target cable.
(C) Figure 14(C) shows that the spectrum intensities of all frequencies are low. Then, it is determined that the cable to which the magnetic sensor 40 is applied is passing no pilot signals nor other signals, and therefore, that the cable is not the target cable.

In this way, the alternating voltage signals detected by the magnetic sensor 40 are added up along a frequency axis to detect the characteristics of a frequency distribution of the detected signals. The detected characteristics are compared with those of a reference frequency distribution, to correctly identify the target cable.

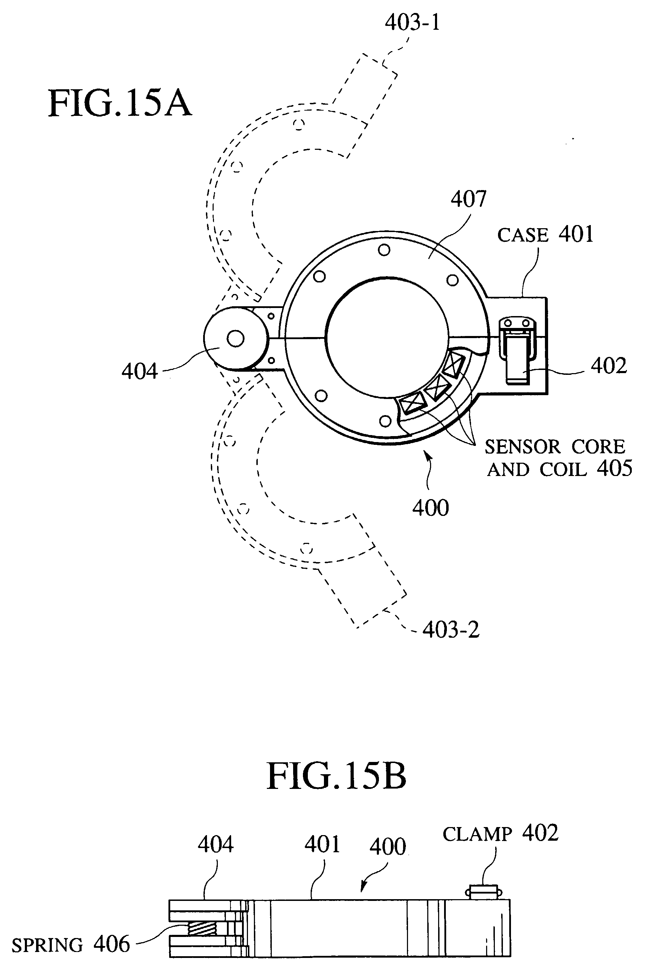

The four sensing coils PX1, PX2, PY1, and PY2 of the magnetic sensor 40 are each a single-body device having a core. Instead, each sensing coil may have a divided structure. A magnetic sensor 400 employing such divided structure will be explained with reference to Figs. 15A and 15B to 17. The magnetic sensor 400 realizes improved sensitivity to the pilot signals.

The magnetic sensor 400 consists of sensing coils PX1, PX2, PY1, and PY2 arranged in a case 401. Each of the sensing coils is composed of three coil segments 405 serving as magnetoelectric converter elements that are circumferentially arranged adjacent to each other and are connected in series.

The case 401 consists of semi-annular half cases 403-1 and 403-2 that are joined together with a hinge 404 and a clamp 402. The half cases 403-1 and 403-2 are opened and closed around the hinge 404 and are fixed together with the clamp 402.

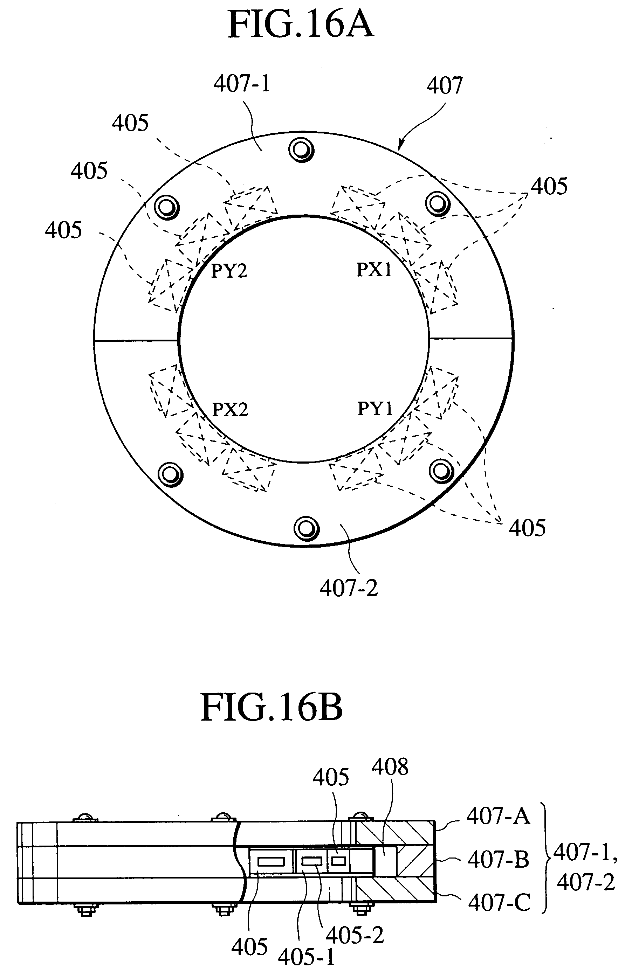

The case 401 houses a magnetic shield case 407 as shown in Fig. 16. The shield case 407 is annular and U-shaped in section with an opening oriented toward the radial center of the shield case 407. The shield case 407 is composed of semi-annular half shield cases 407-1 and 407-2 that are housed in the half cases 403-1 and 403-2, respectively.

In Fig. 16B, each of the half shield cases 407-1 and 407-2 has a three-layer structure consisting of shield cases 407-A, 407-B, and 407-C to form a U-shaped section.

The sensing coils PX1, PX2, PY1, and PY2 are each composed of three coil segments 405 and are arranged at predetermined positions in a U-shaped recess 408 of the shield case 407. Each of the coil segments 405 is made of a coil 405-1 serving as a magnetoelectric converting element and a core 405-2 around which the coil 405-1 is wound so that the coil 405-1 may cross diametrical magnetic flux emanating from the cable 15.

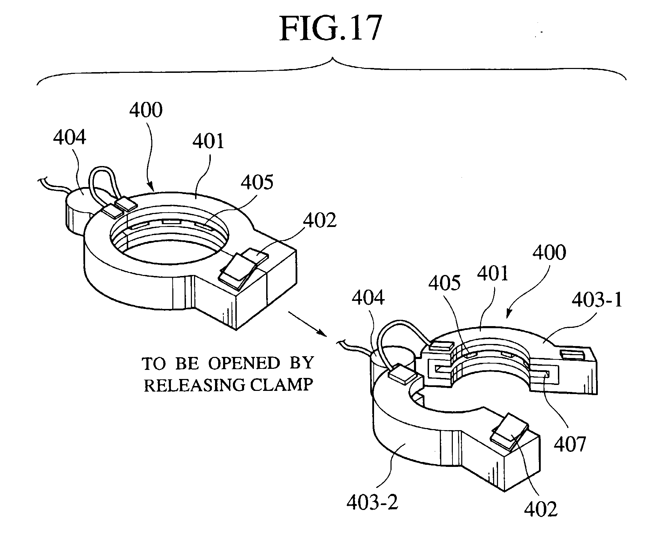

Figure 17 shows the magnetic sensor 400 to be attached to the cable 15. The clamp 402 is released to open the half cases 403-1 and 403-2, and the cable is placed between the half cases 403-1 and 403-2. Then, the half cases 403-1 and 403-2 are closed, and the clamp 402 is fastened.

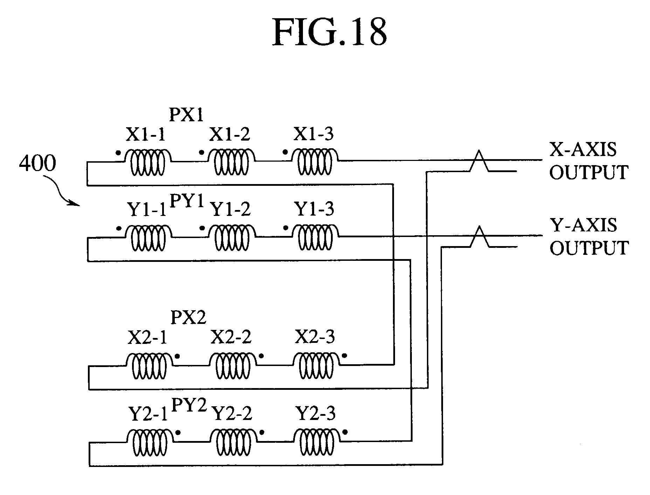

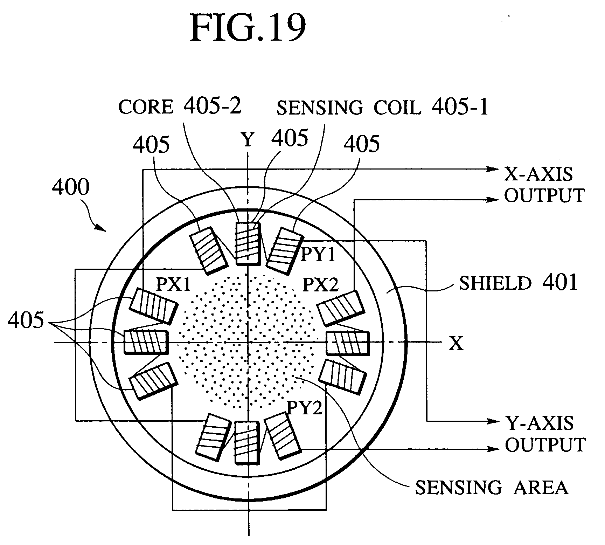

Figures 18 and 19 show the structure of the magnetic sensor 400. In each of the sensing coils PX1, PX2, PY1, and PY2, the coil segments 405 are wound in the same direction, and the coil segments 405 are connected in series. The sensing coils PX1 and PX2 that face each other on the X-axis are connected in series and are oriented to add up induced voltages when magnetic flux passes through the sensing coils PX1 and PX2 in the same direction. The sensing coils PY1 and PY2 that face each other on the Y-axis are similarly arranged. In Fig. 18, a dot "•" indicates the polarity of a sensing coil.

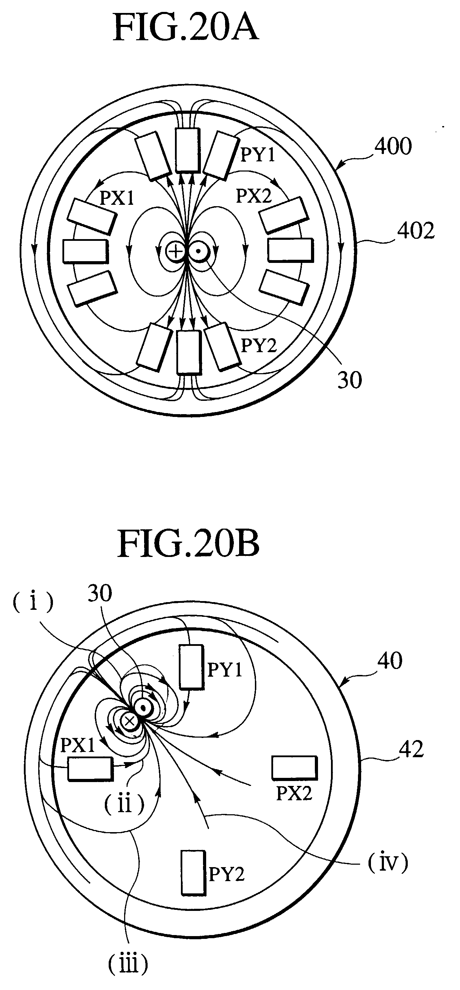

The magnetic sensor 400 functions like the magnetic sensor 40 of Fig. 9. The flux detecting capacity of the magnetic sensor 400, however, is superior to that of magnetic sensor 40. The reason of this will be explained. In Fig. 20A, a quad 30 that is passing pilot signals is at the center of the cable 15. In this case, magnetic flux crosses not only the center coil segment of each sensing coil but also the side coil segment thereof. As a result, each sensing coil realizes an improved sensitivity compared with the sensing coil composed of a single coil segment.

Figure 20B shows the magnetic sensor 40 of Fig. 9. The quad 30 that is passing the pilot signals is at a side of the cable 15 between the sensing coils PX1 and PY1. In this example, the distances between the quad 30 and the sensing coils PX1 and PY1 are each greater than the distance between the quad 30 and the magnetic shield 42. Leakage flux emanating from the quad 30 does not effectively pass through the sensing coils PX1 and PY1. Instead, the leakage flux mostly passes through the magnetic shield 42, to deteriorate the sensitivity of the magnetic sensor 40.

In Fig. 20B, the leakage flux emanating from the quad 30 is mostly magnetic flux (i) that passes through magnetic shields (not shown) existing on the front and back sides of the drawing and the magnetic shield 42. Weak magnetic flux (ii) passes through the sensing coils PX1 and PY1. Magnetic flux (iii) is ineffective for the sensing coils. Very weak magnetic flux (iv) may pass through the other sensing coils PX2 and PY2. As a result, the magnetic sensor 40 is insensitive to the leakage flux.

To improve the sensitivity of the magnetic sensor 40, the circumferential width of each of the sensing coils PX1, PX2, PY1, and PY2 may be increased to reduce a gap between the adjacent sensing coils, e.g., a gap between the sensing coils PX1 and PY1. Magnetic fields produced by the pilot signals have very small magnetic poles, which are determined by the distance between the conductors that are passing the pilot signals and are in the range of 0.5 mm to 1.0 mm. As a result, if the conductors that are passing the pilot signals are around the axis of any sensing coil, the sensing coil will never catch magnetic flux produced around the conductors because the magnetic flux simply passes through a hollow formed inside the sensing coil. This means that simply expanding the circumferential width of each sensing coil results only in deteriorating the sensitivity of the sensing coil to magnetic flux.

To solve the problems, the magnetic sensor 400 of Figs. 19 and 20A employs the sensing coils PX1, PX2, PY1, and PY2 each made of three coil segments 405 that are circumferentially arranged adjacent to each other. Compared with the magnetic sensor 40 of Figs. 9 and 10, the magnetic sensor 400 shows uniform sensitivity irrespective of the position of the quad 30 that is passing pilot signals, to correctly identify the target cable 15.

When employing alternating pilot signals of two or more phases, any one of the magnetic sensors 40 and 400 of the present invention improves the sensitivity thereof if a thickness D in a cable length direction of each sensing coil is made smaller than a strand pitch L of a pair of stranded conductors or a quad in the target cable 15. It is preferable to make D/L = 1/3 or smaller, preferably, D/L = 1/4 or smaller. The reason of this will be explained.

When 2-phase pilot signals are infused into an optional quad 30 in the target cable 15 as shown in Fig. 6, the pilot signals produce a rotating magnetic field around the quad 30 at any section of the cable 15 as shown in Fig. 8. The quad 30 is stranded in the cable 15 at pitches of 40 mm to 300 mm as shown in Fig. 4. As a result, the pilot signals produce a spirally rotating magnetic field at every moment in the longitudinal direction of the cable 15.

The rotating magnetic field in the longitudinal direction has opposite phases at two points that are distanced from each other by half the strand pitch L. If the thickness D of each sensing coil is about half the strand pitch L (D = L/2), the same sensing coil may simultaneously detect the magnetic fields of opposite phases, to provide a detected output of nearly zero. To avoid this, the thickness D of each sensing coil of the magnetic sensors 40 and 400 must be D/L <= 1/3 at the maximum, preferably D/L <= 1/4. This improves the sensitivity of the magnetic sensors 40 and 400 to diametrical leakage flux emanating from a quad or a pair of stranded conductors that pass the pilot signals.

As shown in Fig. 16B, the magnetic shield 407 of each of the magnetic sensors 40 and 400 has a U-shaped section with the recess 408. The sensing coils PX1, PX2, PY1, and PY2 (in the magnetic sensor 40 of Fig. 9) and the coil segments 405 (in the magnetic sensor 400 of Fig. 15A) are arranged in the recess 408 and are covered with the magnetic shields 407-A to 407-C to block external magnetic flux from entering into the sensing coils and coil segments from the side and peripheral directions. As a result, the sensing coils and coil segments detect only diametrical leakage flux emanating from the cable 15. This improves the directivity of the magnetic sensors 40 and 400 with respect to the diametrical leakage flux.

These techniques are also applicable to magnetic sensors employing sensing coils arranged at two poles, or magnetic sensors employing Hall elements or magnetic resistance elements.

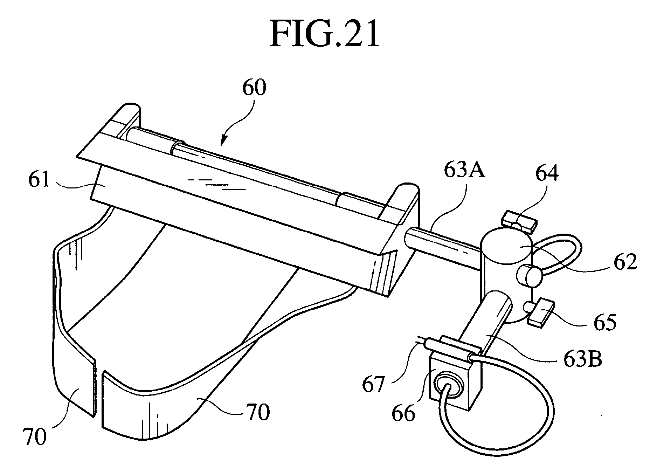

A pilot signal infuser 60 of the present invention for infusing pilot signals into optional four adjacent conductors at an end of the target cable 15 will be explained with reference to Fig. 21, etc. In the following explanation, four conductors form a temporary quad. The conductors of the temporary quad are connected to contacts of the infuser 60, respectively. This is substantially equal to connecting the contacts of the infuser 60 to four conductors of an actual star quad.

The infuser 60 has a base 61 for supporting the whole of the infuser 60 along the sheath of the target cable 15. A first arm 63A is fixed to the base 61 with screws. An end of the first arm 63A is connected to a second arm 63B with a joint 62. The joint 62 has a first adjuster screw 64 for fixing the second arm 63B to the first arm 63A at an optional angle in a vertical plane. The joint 62 also has a second adjuster screw 65 for fixing the second arm 63B at an optional angle around the axis of the second arm 63B.

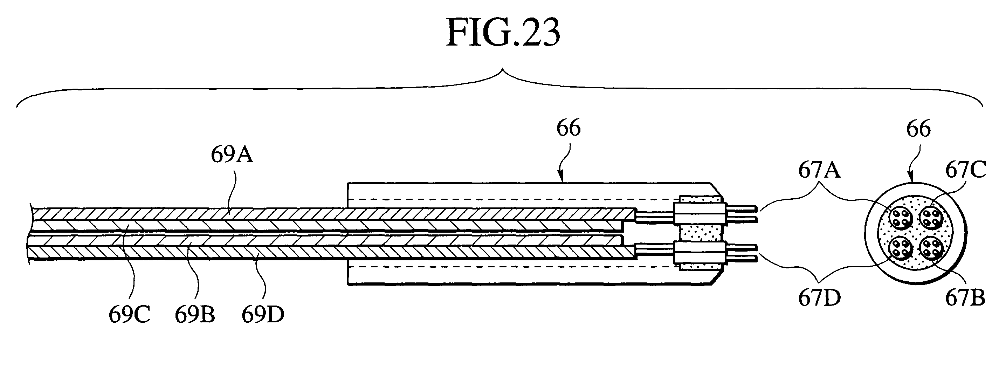

An end of the second arm 63B has a head 66 having four contacts 67A to 67D as shown in Fig. 23. Each of the contacts 67A to 67D has four thin probes. Each of the probes incorporates a spring so that the probe may independently move along the axis of the head 66. The contacts 67A to 67D are connected to leads 69A to 69D, respectively, to guide pilot signals from the pilot signal generator 12 (Fig. 7).

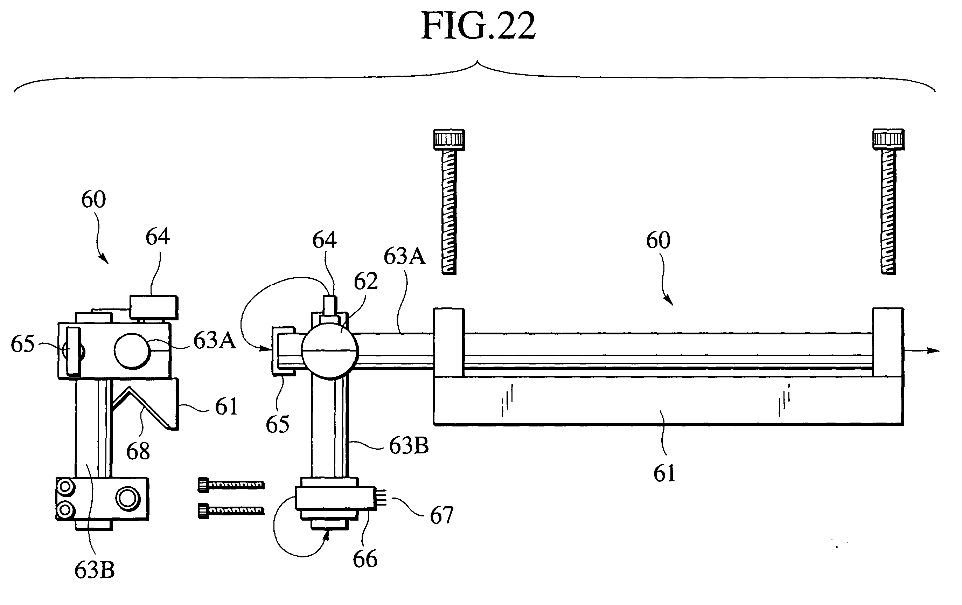

In Fig. 22, the base 61 has an inward right-angled corner to be attached to a cable, and silicon rubber 68 is applied to this part to prevent slippage. In Fig. 21, the first arm 63A has a belt 70 having a magic fastener to speedily fix the infuser 60 to a cable.

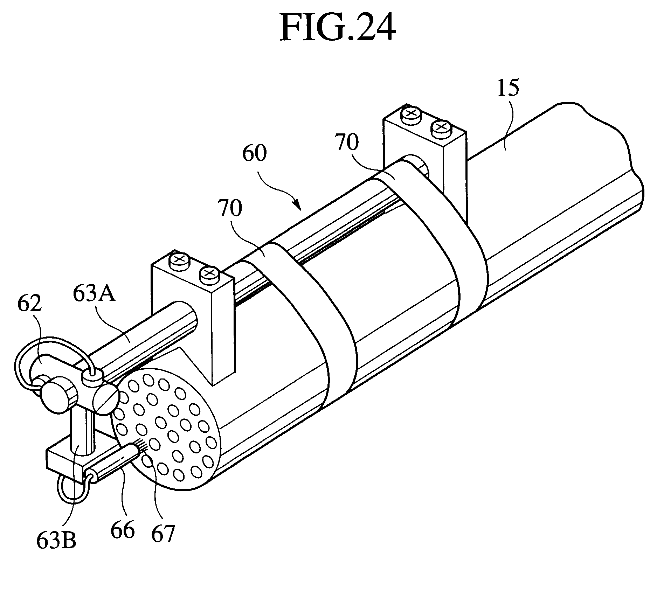

The infuser 60 is used to infuse pilot signals into an end of a target cable. In Fig. 24, the base 61 is attached to the target cable 15 in the vicinity of an end of the target cable 15, and the magic band 70 is wound around and fixed to the target cable 15.

The first and second adjuster screws 64 and 65 are manipulated to adjust the position of the head 66 with respect to the end face of the cable 15. The contacts 67A to 67D are pressed to optional four conductors that form a temporary quad in the target cable 15.

Thereafter, the pilot signal generator 12 generates pilot signals, which are infused into the conductors through the contacts 67A to 67D.

Optional four conductors that form a temporary quad will be explained. As shown in Figs. 2 to 4, star quads in the cable 15 are collected in, for example, 100-pair units (the number of pairs that forms a unit differs depending on the diameter of a conductor) to form quad bundles 22. For example, one of the quad bundles is set at the center of the cable 15, five to seven quad bundles in the next layer around the center quad bundle, other quad bundles around them, and the like. These quad bundles 22 are covered with a cable sheath 20 to form the cable 15. The conductors 23 in a given quad bundle 22 are close to each other anywhere along the length of the cable 15. Accordingly, instead of infusing pilot signals into four conductors that form a true quad, infusing the pilot signals into adjacent four conductors in a given quad bundle will be proper for correctly identifying the target cable 15.

The infuser 60 is easily attached to an end of a target cable to infuse pilot signals into the target cable. Usually, a cable removing work for identifying, cutting, and removing a target cable is required to be finished within a limited time. The infuser 60 is helpful to quickly and simply carry out a preparatory work of infusing pilot signals into a target cable.

Instead of the magic band 70, spikes may be formed on the inner side of the base 61 to stick in the sheath of the cable, or a belt having an over-center buckle, or a sucker may be used to fix the infuser 60 to a target cable.

Although the embodiment mentioned above infuses alternating 2-phase pilot signals into four conductors, respectively, this does not limit the present invention. For example, alternating single-phase pilot signals may be infused into two conductors. In this case, the infuser 60 may have two contacts. Alternatively, alternating 3-phase or N-phase (N is a suitable integer more than three) pilot signals may be infused into tree or N conductors with the phases thereof respectively shifted by 120 or 360/N degrees. In this case, the infuser 60 may have three or N contacts.

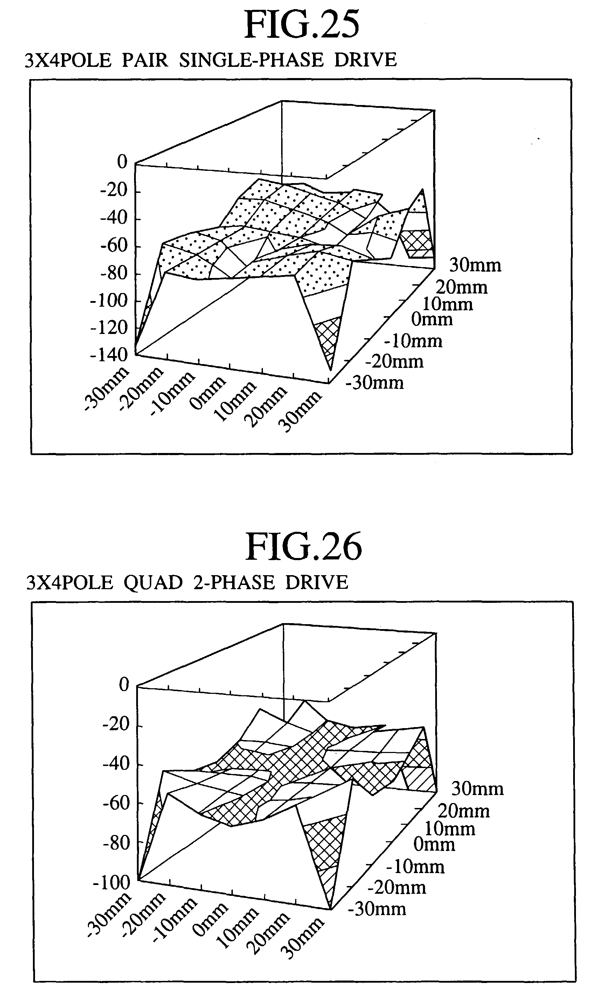

Simulation results based on the cable identification method of the present invention will be explained with reference to Tables 1 to 4 and graphs shown in Figs. 25 to 28.

Table 1

| Four sensing coils each having three coil segments are employed to form a magnetic sensor, and alternating single-phase pilot signals are infused into a pair of stranded conductors. | | | | | | | |
|---|---|---|---|---|---|---|---|
|  | -30mm | -20mm | -10mm | 0mm | 10mm | 20mm | 30mm |
| -30mm |  | -73.4 | -75.8 | -73 | -68.9 | -64.5 |  |
| -20mm | -66.9 | -72.4 | -85.6 | -74.1 | -67.2 | -61.6 | -65.4 |
| -10mm | -72.1 | -75.5 | -96.1 | -78.2 | -71.7 | -68.3 | -77.7 |
| 0mm | -80.4 | -76.2 | -77.3 | -80.7 | -84.1 | -96.4 | -89.9 |
| 10mm | -67.1 | -65.9 | -70.3 | -76.5 | -88.6 | -72.9 | -62.6 |
| 20mm | -59.7 | -61.6 | -67.9 | -74.2 | -87.3 | -78.6 | -57.5 |
| 30mm |  | -72.8 | -81 | -73.1 | -76.5 |  |  |

Table 2

| | -30mm | -20mm | -10mm | 0mm | 10mm | 20mm | 30mm |
|---|---|---|---|---|---|---|---|
| Four sensing coils each having three coil segments are employed to form a magnetic sensor, and alternating two-phase pilot signals are infused into a quad. | | | | | | | |
| -30mm | | -50.7 | -60 | -63.7 | -58.8 | -49.5 | |
| -20mm | -51.1 | -56 | -58.7 | -60.7 | -59 | -54.9 | -44.9 |
| -10mm | -60.4 | -59.4 | -59.5 | -60.3 | -59.7 | -59.5 | -63 |
| 0mm | -63.8 | -60.9 | -60.5 | -60.7 | -60 | -61.3 | -64.9 |
| 10mm | -59.1 | -58.8 | -60.1 | -60.3 | -58.7 | -58.7 | -57.8 |
| 20mm | -48 | -54.8 | -60.1 | -61.5 | -57.1 | -54.1 | -50.4 |
| 30mm | | -49.2 | -62.3 | -64.2 | -59.9 | | |

Table 3

| | -30mm | -20mm | -10mm | 0mm | 10mm | 20mm | 30mm |
|---|---|---|---|---|---|---|---|
| Four sensing coils each having a single coil segment are employed to form a magnetic sensor, and alternating two-phase pilot signals are infused into a quad. | | | | | | | |
| -30mm | | -78.7 | -73.2 | -71.6 | -78.6 | -82.7 | |
| -20mm | -82 | -77.8 | -75 | -74.8 | -78.7 | -79.9 | -80.8 |
| -10mm | -78.2 | -76.9 | -76.8 | -77.2 | -78.2 | -77.2 | -74 |
| 0mm | -73.5 | -76.1 | -76.8 | -77.6 | -78 | -76.2 | -72.3 |
| 10mm | -74 | -76.5 | -77.5 | -77.6 | -78.1 | -78.1 | -77.4 |
| 20mm | -79.5 | -79.1 | -78.1 | -76.6 | -77.6 | -79.8 | -83.3 |
| 30mm | | -81.7 | -77.9 | -73.8 | -75.5 | -81 | |

Table 4

| | -30mm | -20mm | -10mm | 0mm | 10mm | 20mm | 30mm |
|---|---|---|---|---|---|---|---|
| Four sensing coils each having a single coil segment are employed to form a magnetic sensor, and alternating single-phase pilot signals are infused into a pair of stranded conductors. | | | | | | | |
| -30mm | | -104.3 | -85.1 | -75 | -95.4 | -81.4 | |
| -20mm | -105.7 | -83.2 | -76.4 | -90.1 | -111.1 | -88.6 | -82 |
| -10mm | -88.7 | -75.6 | -75.6 | -84.4 | -91.5 | -99.2 | -100.1 |
| 0mm | -74.7 | -78.4 | -80.4 | -81.2 | -81.8 | -85.6 | -88.9 |
| 10mm | -83.8 | -75.8 | -91.1 | -82.1 | -78.5 | -76.3 | -74.9 |
| 20mm | -95.9 | -84.4 | -106.4 | -85.4 | -76.7 | -78.1 | -86.2 |

Table 4 (continued)

| Four sensing coils each having a single coil segment are employed to form a magnetic sensor, and alternating single-phase pilot signals are infused into a pair of stranded conductors. | | | | | | | |
|---|---|---|---|---|---|---|---|
|  | -30mm | -20mm | -10mm | 0mm | 10mm | 20mm | 30mm |
| 30mm |  |  | -90.4 | -88 | -75.1 | -90.9 |  |

Table 1 shows results of simulations carried out by infusing alternating single-phase pilot signals into a pair of stranded conductors of a target cable and by arranging a sensing coil made of three coil segments at each of four poles. These sensing coils form the magnetic sensor 400. In Table 1, the pair stranded conductors were set at the center (0 mm, 0 mm) of the target cable, and magnetic-field intensities were simulated along an X-axis (horizontal axis) and a Y-axis (vertical axis). Table 1 corresponds to the graph of Fig. 25.

Table 2 shows results of simulations carried out by infusing alternating 2-phase pilot signals into a quad in a target cable and by arranging a sensing coil made of three coil segments at each of four poles. These sensing coils form the magnetic sensor 400. In Table 2, the quad was set at the center (0 mm, 0 mm) of the target cable, and magnetic-field intensities were simulated along an X-axis (horizontal axis) and a Y-axis (vertical axis). Table 2 corresponds to the graph of Fig. 26.

From Tables 1 and 2, it is understood that the magnetic sensor 400 of the same specification shows better sensitivity to identify the target cable with alternating 2-phase pilot signals than with alternating single-phase pilot signals when a quad or a pair of stranded conductors is at a position of (±30 mm, ±30mm) (at any one of the four corners of each graph).

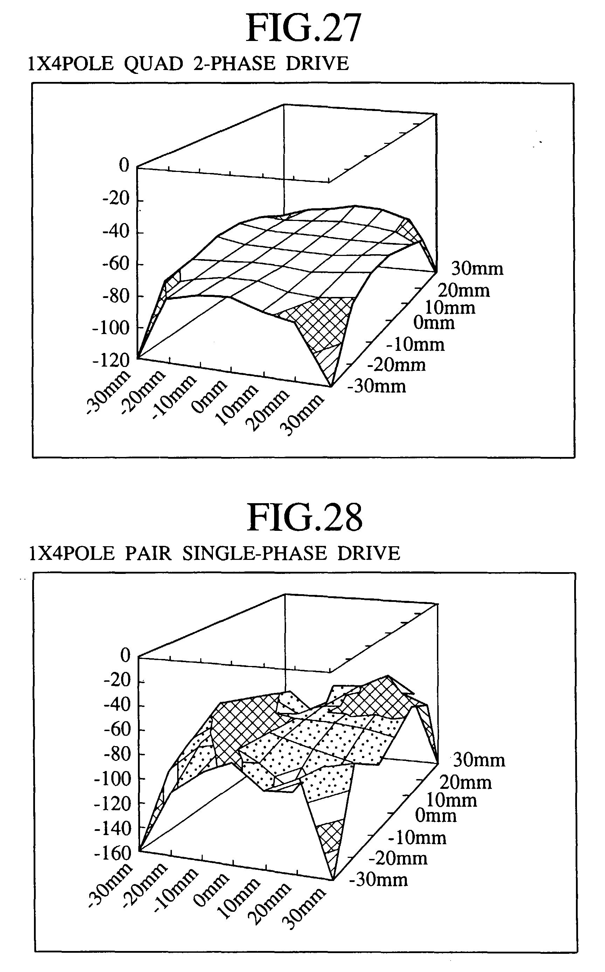

Table 3 shows results of simulations carried out by infusing alternating 2-phase pilot signals into a quad in a target cable and by arranging a sensing coil made of a single coil segment at each of four poles. These sensing coils form the magnetic sensor 40. In Table 3, the quad was set at the center (0 mm, 0 mm) of the target cable, and magnetic-field intensities were simulated along an X-axis (horizontal axis) and a Y-axis (vertical axis). Table 3 corresponds to the graph of Fig. 27.

Table 4 shows results of simulations carried out by infusing alternating single-phase pilot signals into a pair of stranded conductors in a target cable and by arranging a sensing coil made of a single coil segment at each of four poles. These sensing coils form the magnetic sensor 40. In Table 4, the pair stranded conductors were set at the center (0 mm, 0 mm) of the target cable, and magnetic-field intensities were simulated along an X-axis (horizontal axis) and a Y-axis (vertical axis). Table 4 corresponds to the graph of Fig. 28.

From Tables 3 and 4, it is understood that the magnetic sensor 40 of the same specification shows better uniformity to identify the target cable with alternating 2-phase pilot signals than with alternating single-phase pilot signals without regard to the position of the conductors that pass the pilot signals in the target cable.

When comparing Table 1 and Fig. 25 with Table 4 and Fig. 28, and Table 2 and Fig. 26 with Table 3 and Fig. 27, it is understood that the magnetic sensor 400 provides higher measurements and more uniform sensitivity than the magnetic sensor 40 irrespective of whether the pilot signals are of single phase or of two phases and irrespective of the position of the quad or pair of stranded conductors.

Consequently, the following is said:

(1) The reliability of target cable identification more improves by infusing alternating multiphase pilot signals into three or more conductors of a target cable than by infusing alternating single-phase pilot signals into two conductors.

This is true for both the magnetic sensor that arranges sensing coils at two poles and the magnetic sensor that arranges sensing coils at four poles with each of the sensing coils being composed of a single coil segment or a plurality of coil segments.

(2) Alternating multi-frequency multiphase pilot signals are more resistive to external noise flux and more reliable in identifying a target cable than alternating single-frequency multiphase pilot signals.

This is true for both the magnetic sensor that arranges sensing coils at two poles and the magnetic sensor that arranges sensing coils at four poles with each of the sensing coils being composed of a single coil segment or a plurality of coil segments.

(3) The magnetic sensor that arranges sensing coils at four poles is more sensitive, stable, and reliable in identifying a target cable than the magnetic sensor that arranges sensing coils at two poles.

(4) The sensing coil composed of a plurality of coil segments shows better sensitivity than the sensing coil composed of a single coil segment in either of the magnetic sensor that arranges the sensing coils at four poles and the magnetic sensor that arranges the sensing coils at two poles.

Although the embodiments mentioned above employ sensing coils for detecting leakage flux emanating from conductors or a quad, this does not limit the present invention. For example, a single or plurality of Hall devices or magnetic resistance devices may be arranged at each pole to detect leakage flux.

## Claims

1.  A method of identifying a target cable containing many conductors covered with a cable sheath, comprising the steps of:

    short-circuiting all conductors of the target cable at a first end of the target cable;
    infusing a pilot signal into a plurality of the conductors at a second end of the target cable;
    arranging a magnetic sensor for detecting leakage flux, around an optional cable at a site where the target cable is going to be identified; and
    determining, according to the output of the magnetic sensor, whether or not the optional cable is the target cable.

2.  A method of identifying a target cable containing many conductors covered with a cable sheath, comprising the steps of:

    short-circuiting all conductors of the target cable at a first end of the target cable;
    infusing alternating pilot signals into a plurality of the conductors at a second end of the target cable, the pilot signals are of a single frequency and different phases shifted by a suitable angle to be able to cause a rotating magnetic field of leakage flux from the conductors around the target cable;
    arranging a magnetoelectric converter around an optional cable at a working site where the target cable is going to be identified, so that diametrical magnetic flux emanating from the optional cable may cross the magnetoelectric converter;
    comparing a composite waveform of voltage signals provided by the magnetoelectric converter with a reference waveform representing the pilot signals; and
    determining, according to a result of the comparison, whether or not the optional cable is the target cable.

3.  A method of identifying a target cable containing many conductors covered with a cable sheath, comprising the steps of:

    short-circuiting all conductors of the target cable at a first end of the target cable;
    infusing alternating pilot signals of different frequencies into at least a pair of the conductors at a second end of the target cable;
    arranging a magnetoelectric converter around an optional cable at a site where the target cable is going to be identified, so that diametrical magnetic flux emanating from the optional cable may cross the magnetoelectric converter;
    analyzing a voltage signal induced by the magnetic flux in the magnetic converter into a frequency distribution, and comparing the frequency distribution with a frequency distribution of the pilot signals; and
    determining, according to a result of the comparison, whether or not the optional cable is the target cable.

4.  The method of any one of claims 1 to 3, comprising the step of applying conductive material to the ends of all conductors of the target cable, thereby short-circuiting the conductors at the first end of the target cable.

5.  The method of any one of claims 2 and 3, comprising the step of, if the conductors are configured into star quads, infusing a first alternating pilot signal of a single frequency or a plurality of frequencies into opposing two of four conductors of an optional one of the quads, and a second alternating pilot signal whose frequency (frequencies) is the same as the frequency (frequencies) of the first alternating pilot signal and whose phase is shifted by 90 degrees from the phase of the first alternating pilot signal into the remaining two conductors of the optional quad.

6.  The method of claim 3, comprising the steps of:

    arranging four magnetoelectric converters at intervals of 90 degrees around the optional cable;
    combining voltage signals induced by opposing two of the four magnetoelectric converters into a first composite waveform and combining voltage signals induced by the remaining two magnetoelectric converters into a second composite waveform;

adding up the first and second composite waveforms into a sum waveform;

comparing the sum waveform with a reference waveform representing the pilot signals; and

determining, according to a result of the comparison, whether or not the optional cable is the target cable.

7. A cable identifying apparatus identifying a target cable, comprising:

conductive material placed at a first end of the target cable to short-circuit all conductors contained in the target cable;

a pilot signal infuser infusing a pilot signal into a plurality of the conductors at a second end of the target cable;

a magnetic sensor applied to an optional cable at a working site where the target cable is going to be identified, to sense a leakage magnetic flux of the pilot signal from the optional cable; and

an evaluation circuit determining whether or not the optional cable is the target cable, according to the output of the magnetic sensor.

8. A cable identifying apparatus short-circuiting all conductors contained in a target cable at a first end of the target cable, infusing alternating pilot signals having the same frequency and phases shifted by a predetermined angle from each other into an optional number of the conductors at a second end of the target cable, checking, at a working site, to see if an optional cable leaks magnetic flux caused by the pilot signals, and determining whether or not the optional cable is the target cable, comprising:

a magnetic sensor having at least a pair of magnetoelectric converters that are oppositely arranged around the optional cable at the site, to cross diametrical magnetic flux emanating from the optional cable; and

a signal processor combining voltage signals provided by each pair of the magnetoelectric converters into a composite waveform, comparing the composite waveform with a reference waveform, and determining whether or not the optional cable is the target cable.

9. The cable identifying apparatus of claim 8, wherein:

four magnetoelectric converters are arranged at intervals of 90 degrees around the optional cable at the site; and

voltage signals induced by opposing two of the magnetoelectric converters are combined into a first composite waveform, voltage signals induced by the remaining two magnetoelectric converters are combined into a second composite waveform, and the first and second composite waveforms are combined into a sum waveform to be compared with a reference waveform.

10. A cable identifying apparatus short-circuiting all conductors contained in a target cable at a first end of the target cable, infusing alternating pilot signals of a single frequency into an optional number of the conductors at a second end of the target cable, checking, at a working site, to see if an optional cable leaks magnetic flux caused by the pilot signals, and determining whether or not the optional cable is the target cable, comprising:

a magnetic sensor having magnetoelectric converters arranged around the optional cable at the site, to cross diametrical magnetic flux emanating from the optional cable;

a spectrum analyzer carrying out a frequency spectrum analysis on voltage signals provided by the magnetoelectric converters;

a frequency spectrum distribution processor adding up frequency spectrum intensities provided by the spectrum analyzer and providing a frequency spectrum distribution; and

a comparator comparing the frequency spectrum distribution with a reference frequency spectrum distribution representing the pilot signals, and according to a result of the comparison, determining whether or not the optional cable is the target cable.

11. The cable identifying apparatus of claim 10, wherein the pilot signals involve different frequencies.

12. The cable identifying apparatus of any one of claims 8 and 10, wherein the thickness of each of the magnetoelectric converters in a longitudinal direction along the target cable is 1/4 or smaller of a strand pitch of the conductors that pass the pilot signals.

13. The cable identifying apparatus of any one of claims 8 and 10, further comprising:

a magnetic shield shielding the outer and side faces of each of the magnetoelectric converters and opening the inner face thereof.

14. The cable identifying apparatus of any one of claims 8 and 10, wherein:

four magnetoelectric converters are arranged at intervals of 90 degrees around the optional cable at the site, each of the magnetoelectric converters being composed of converter elements that are circumferentially arranged side by side and are connected in series; and
voltage signals induced by each opposing two of the magnetoelectric converters are combined into a composite waveform.

15. A pilot signal infuser infusing alternating pilot signals to identify a target cable into an optional number of conductors covered with a cable sheath in the target cable, comprising:

a base attached to the sheath of the target cable;
an arm supported by the base and extending toward an end face of the target cable;
contacts attached to the arm and brought in contact with end faces of the optional number of conductors, respectively, at the end face of the target cable; and
leads connected to the contacts, respectively, to guide the pilot signals.

16. The pilot signal infuser of claim 15, wherein:

each of the contacts is composed of independently movable probes incorporating a spring therein.

17. The pilot signal infuser of claim 15, wherein the arm has:

a first adjusting mechanism for adjusting the positions of the contacts in an axial direction along the target cable; and
a second adjusting mechanism for adjusting the positions of the contacts m a direction orthogonal to the axial direction.

18. A pilot signal generator, comprising:

a frequency signal generator for generating alternating signals of a given frequency;
a first output circuit providing a first pilot signal of a given current intensity based on the generated alternating signals;
a second output circuit providing a second pilot signal of a given current intensity base on the generated alternating signals;
a first isolation transformer arranged between the frequency signal generator and the first output circuit; and
a second isolation transformer arranged between the frequency signal generator and the second output circuit.

19. The pilot signal generator of claim 18, wherein the frequency signal generator generates alternating signals of different frequencies.

20. The pilot signal generator of any one of claims 18 and 19, wherein the frequency signal generator provides the first and second output circuits with alternating signals of the same frequency having phases shifted by 90 degrees from each other.

# FIG.1

TERMINAL BOX 10

AERIAL SECTION 11

PILOT SIGNAL GENERATOR 12

UNDERGROUND

SENSOR AND ELECTRIC CUTTER 13

SHORT-CIRCUITED END 14

TARGET CABLE 15

MH 1

MH 2

17

BRANCHING 18

MASTER STATION

16

DEX   MDF

# FIG.2

# FIG.3

# FIG.4

15  20

30

30A
30B
30C

30

30D

# FIG.5

30C

30A

30B

30D

A-B : PAIR 1
C-D : PAIR 2

30

# FIG.6

PILOT SIGNAL GENERATOR 12

30A

TARGET CABLE

30B    F1

STAR QUAD

30C    F2

MAGNETIC
SENSOR 40

30

SHORT-CIRCUITED END 14

30D

13    → DETECTED SIGNAL

PILOT SIGNAL RECEIVER 41

PILOT SIGNAL GENERATING EXPRESSIONS : $F1= \Sigma \sin(\omega nt)$
$F2= \Sigma \sin(\omega nt-(\pi /2))$ : n=1,2,3,4,5

EP 1 014 099 A2

# FIG.7

EP 1 014 099 A2

# FIG.8

(i)

(ii)

(iii)

(iv)

(v)

(vi)

(vii)

(viii)

30

# FIG.9

# FIG.10

# FIG.11

EP 1 014 099 A2

PREAMPLIFIER     BAND-PASS     MIDDLE
                 FILTER        AMPLIFIER

X-INPUT → [43X] → [44X] → [45X] →

ANTIALIASING
FILTER

MULTIPLEXER → [47] → [D/A] → [DSP] → OUTPUT

Y-INPUT → [43Y] → [44Y] → [45Y] →

46

47      48      49

PILOT SIGNAL RECEIVER

41

# FIG.12

49

49-1        49-2        49-3

→ [SPECTRUM ANALYZER] → [SPECTRUM INTENSITY ADDER] → [COMPARATOR] → OUTPUT

# FIG.13

START

↓

ANALYZE  FREQUENCY  SPECTRA ⟩∼S05

↓

ADD  UP  SPECTRUM  INTENSITIES
FOR  EACH  FREQUENCY ⟩∼S10

↓

FETCH  REFERENCE  FREQUENCY
SPECTRUM  DISTRIBUTION ⟩∼S15

↓

COMPARE  FREQUENCY
SPECTRUM  DISTRIBUTIONS ⟩∼S20

↓

PROVIDE  RESULT ⟩∼S25

↓

END

# FIG.14

SPECTRUM INTENSITY (A)
(TARGET CABLE)

SPECTRUM INTENSITY (B)
(ACTIVE CABLE)

SPECTRUM INTENSITY (C)
(NON-TARGET CABLE)

403-1

# FIG.15A

407

CASE 401

404

402

SENSOR CORE
AND COIL 405

400

403-2

# FIG.15B

404    401    400    CLAMP 402

SPRING 406

# FIG.16A

407-1  407

405

405

405  405

405

PY2  PX1

PX2  PY1

405

407-2

# FIG.16B

405  408

407-A

407-B  407-1,
407-2

407-C

405  405-2
405-1

# FIG.17

TO BE OPENED BY
RELEASING CLAMP

# FIG.18

# FIG.19

CORE 405-2    SENSING COIL 405-1

405    Y    405    405

400

PY1

PX1    PX2

X-AXIS
OUTPUT

SHIELD 401

405

X

PY2

Y-AXIS
OUTPUT

SENSING AREA

# FIG.20A

# FIG.20B

# FIG.21

# FIG.22

EP 1 014 099 A2

# FIG.23

EP 1 014 099 A2

# FIG.24

# FIG.25

3X4POLE PAIR SINGLE-PHASE DRIVE

# FIG.26

3X4POLE QUAD 2-PHASE DRIVE

# FIG.27

1X4POLE QUAD 2-PHASE DRIVE

# FIG.28

1X4POLE PAIR SINGLE-PHASE DRIVE